# EUROPEAN PATENT APPLICATION

(11) **EP 1 494 074 A1**
(43) Date of publication of application: **05.01.2005**
(21) Application number: 03254139.3
(22) Date of filing: 30.06.2003
(51) Int. Cl.: G03F 7/20, G03F 9/00

(54) **Lithographic apparatus and device manufacturing method**

(71) Applicant: ASML Netherlands B.V., 5504 DR Veldhoven (NL)
(72) Inventor: Mulkens, Johannes Catharinus Hubertus, 5581 AB Waalre (NL); Derksen, Antonius Theodorus Anna Maria, 5623 CB Eindhoven (NL); Lof, Joeri, 5616 BW Eindhoven (NL); Simon, Klaus, 5655 CP Eindhoven (NL); Straaijer, Alexander, 5644 KK Eindhoven (NL); Streefkerk, Bob, 5038 PE Tilburg (NL)
(74) Representative: Leeming, John Gerard

(57) **Abstract**

The pressure and/or height of liquid 11 in a liquid reservoir 10 of an immersion lithography apparatus is obtained by measurement devices 20a, 20b to determine the height and/or tilt of the substrate W.

## Description

The present invention relates to a lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for at least partly filling a space between the final element of said projection system and an object positioned on said substrate table, with liquid.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

It has been proposed to immerse the substrate in a lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system.)

However, submersing the substrate or substrate and substrate table in a bath of liquid (see for example US 4,509,852, hereby incorporated in its entirety by reference) means that there is a large body of liquid that must be accelerated during a scanning exposure. This requires additional or more powerful motors and turbulence in the liquid may lead to undesirable and unpredictable effects.

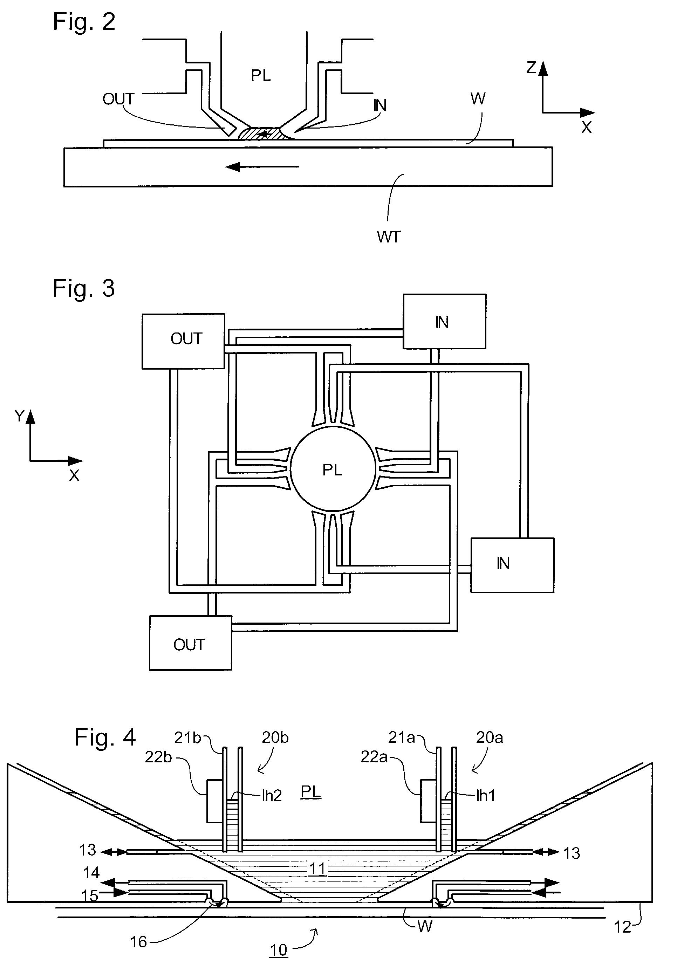

One of the solutions proposed is for a liquid supply system to provide liquid in a localized area between the final element of the projection system and the substrate (the substrate generally has a larger surface area than the final element of the projection system). One way which has been proposed to arrange for this is disclosed in WO 99/49504, hereby incorporated in its entirety by reference. As illustrated in Figures 2 and 3, liquid is supplied by at least one inlet IN onto the substrate, preferably along the direction of movement of the final element relative to the substrate, and is removed by at least one outlet OUT after having passed under the projection system. That is, as the substrate is scanned beneath the element in a -X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the final element relative to the substrate, though this does not need to be the case. Various orientations and numbers of in- and out-lets positioned around the final element are possible, one example is illustrated in Figure 3 in which four sets of an inlet with an outlet on either side are provided in a regular pattern around the final element.

Another solution which has been proposed is to provide the liquid supply system with a seal member which extends along at least a part of a boundary of the space between the final element of the projection system and the substrate table. The seal member is substantially stationary relative to the projection system in the XY plane and a seal is formed between the seal member and the surface of the substrate. Preferably the seal is a contactless seal such as a gas seal.

A problem with such immersion lithography apparatus is that it is difficult to adequately control the relative positions of the projection system and substrate table and hence the thickness of the liquid film between the projection system and the substrate. There are three reasons for this. Firstly, the substrate table and projection lens are hydrodynamically coupled so that the mechanical control of the substrate table position is difficult and an accurate set point is essential. Secondly, the level (height) sensors used in conventional lithography apparatus are not compatible with the liquid reservoirs. Such sensors are generally based around a light beam that is reflected by the substrate at a relatively low angle of incidence and it is difficult to provide the necessary beam directing elements within the space occupied by the immersion liquid. Thirdly, in immersion lithography imaging quality is more sensitive to variations in the Z position of the substrate.

It is an object of the present invention to provide leveling means that can be used in an immersion lithography apparatus.

This and other objects are achieved according to the invention in a lithographic apparatus as specified in the opening paragraph, characterized by:
a measurement device for obtaining the pressure and/or height of liquid in said space.

Since the liquid is confined in the space between the projection system and substrate, any change in the vertical position of the substrate will change the pressure of the liquid hence measurement and/or determination of the pressure or height of the liquid provides a simple result from which the vertical position of the substrate relative to the projection system, or at least changes in it, can be obtained. The exact relationship between pressure and/or height of the liquid and vertical height of the substrate will depend on the shape, size and nature of the liquid supply system and can be calculated or empirically derived for each application of the invention. For example, if the liquid supply system rigidly confines the liquid then changes in the vertical position of the substrate will lead to greater pressure changes than if the liquid is more elastically confined.

Preferably, the pressure and/or height is obtained at two or more points spaced apart in the plane of the substrate. This enables an indication of the tilt of the substrate about one or more axes to be determined.

A particularly simple form of measurement device that may be used in the invention comprises a tube in liquid communication with liquid in the space, the tube having an open end and extending at least in part vertically; and a sensor for measuring the height of the liquid in said tube. The sensor may be an optical or capacitive sensor or employ a series of electrodes successively wetted as the liquid level rises in the tube.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
- providing a liquid to at least partly fill a space between an object on the substrate table and a final element of a projection system used in said step of projecting;
characterized by
obtaining the pressure and/or height of liquid in said space.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm).

Embodiments of the invention will now be described, by way of example only, with reference to the accompanying schematic drawings in which:
Figure 1 depicts a lithographic projection apparatus according to an embodiment of the invention;
Figure 2 is a side view of a prior art liquid supply system;
Figure 3 is a plan view of the prior art liquid supply system of Figure 2; and
Figure 4 depicts the liquid reservoir of the first embodiment of the invention.

In the Figures, corresponding reference symbols indicate corresponding parts.

### Embodiment 1

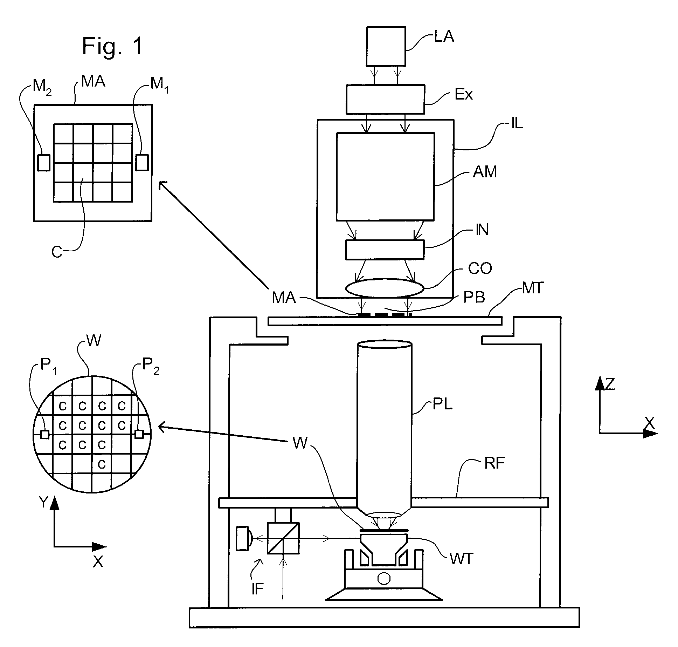

Figure 1 schematically depicts a lithographic projection apparatus according to a particular embodiment of the invention. The apparatus comprises:
· a radiation system Ex, IL, for supplying a projection beam PB of radiation (e.g. DUV radiation), which in this particular case also comprises a radiation source LA;
· a first object table (mask table) MT provided with a mask holder for holding a mask MA (e.g. a reticle), and connected to first positioning means for accurately positioning the mask with respect to item PL;
· a second object table (substrate table) WT provided with a substrate holder for holding a substrate W (e.g. a resist-coated silicon wafer), and connected to second positioning means for accurately positioning the substrate with respect to item PL;
· a projection system ("lens") PL (e.g. a refractive system) for imaging an irradiated portion of the mask MA onto a target portion C (e.g. comprising one or more dies) of the substrate W.
As here depicted, the apparatus is of a transmissive type (e.g. has a transmissive mask). However, in general, it may also be of a reflective type, for example (e.g. with a reflective mask). Alternatively, the apparatus may employ another kind of patterning means, such as a programmable mirror array of a type as referred to above.

The source LA (e.g. an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed *V = Mv*, in which *M* is the magnification of the lens PL (typically, *M* = 1/4 or 1/5). In this manner, a relatively large target portion C can be exposed, without having to compromise on resolution.

Figure 4 shows the liquid reservoir 10 between the projection system PL and the substrate W which is positioned on the substrate stage WT. The liquid reservoir 10 is filled with a liquid 11 having a relatively high refractive index, e.g. water, provided via inlet/outlet ducts 13. The liquid has the effect that the radiation of the projection beam is a shorter wavelength in the liquid than in air or in a vacuum, allowing smaller features to be resolved. It is well known that the resolution limit of a projection system is determined, inter alia, by the wavelength of the projection beam and the numerical aperture of the system. The presence of the liquid may also be regarded as increasing the effective numerical aperture. Furthermore, at fixed numerical aperture, the liquid is effective to increase the depth of field.

The reservoir 10 forms a preferably contactless seal to the substrate W around the image field of the projection lens PL so that the liquid is confined to fill the space between the substrate's primary surface, which faces the projection system PL, and the final optical element of the projection system PL. The reservoir is formed by a seal member 12 positioned below and surrounding the final element of the projection lens PL. Thus, the liquid supply system provides liquid on only a localised area of the substrate. The seal member 12 forms part of the liquid supply system for filling the space between the final element of the projection system and the substrate with a liquid. This liquid is brought into the space below the projection lens and within the seal member 12. The seal member 12 preferably extends a little above the bottom element of the projection lens and the liquid rises above the final element so that a buffer of liquid is provided. The seal member 12 has an inner periphery that at the upper end closely conforms to the shape of the projection system or the final elements thereof and may, e.g. be round. At the bottom the inner periphery closely conforms to the shape of the image field, e.g. rectangular, though this is not necessarily so. The seal member is substantially stationary in the XY plane relative to the projection system though there may be some relative movement in the Z direction (in the direction of the optical axis). A seal is formed between the seal member and the surface of the substrate. This seal is preferably a contactless seal and may be a gas seal.

The liquid 11 is confined in the reservoir 10 by a seal device 16. As illustrated in Figure 2, the seal device is a contactless seal i.e. a gas seal. The gas seal is formed by gas, e.g. air or synthetic air, provided under pressure via inlet 15 to the gap between seal member 12 and substrate W and extracted by first outlet 14. The over pressure on the gas inlet 15, vacuum level or under pressure on the first outlet 14 and the geometry of the gap are arranged so that there is a high-velocity air flow inwards towards the optical axis of the apparatus that confines the liquid 11. As with any seal, some liquid is likely to escape, for example up the first outlet 14.

Three measurement devices 20a, 20b (only two of which are shown in Figure 4) are provided to measure the pressure and/or height of the liquid 11 at three locations spaced apart in the XY plane. In this embodiment, the measurement devices comprise narrow tubes 21a, 21b in liquid communication with the liquid 11 and each having at least a part that extends generally upward. The heights lh1, lh2 of the fluid in the tubes, which are effectively manometers, are measured by sensors 22a, 22b to determine the pressure of the liquid at the point where the tube enters the reservoir 10. The tubes 21a, 21b are preferably narrow so that not too great a volume of liquid enters them but not so narrow that capillary forces affect the measurements. Sensors 22a, 22b may be capacitive sensors, e.g. with two elongate plates on the outside of the tube such that the amount of liquid between the plates affects the capacitance of the two plates. A series of annular or part annular electrodes on the inner or outer walls of the tubes allows the liquid level to be measured in discrete steps, either resistively or capacitively. Optical sensors may also be used with transparent tubes in which case a float or layer of colored liquid immiscible with the immersion liquid may be employed to ease detection of the liquid level. A magnetic float and reed switches and/or Hall effect sensors might also be employed. Other types of pressure sensor may also be used.

The pressure and/or height results are linked to the height and/or tilt of the substrate table in a way dependent on the geometry of the reservoir 10 and the manner in which the liquid is confined. If the liquid is more rigidly confined, there will be a greater pressure or height change with a change in height of the substrate table. An appropriate equation, or look up table, to derive height and/or tilt values can be derived theoretically from knowledge of the relevant characteristics of the reservoir or determined empirically. Because the seal member 12 is stationary relative to the projection system, tilt is not derived directly from the pressure and/or height results but changes in tilt can be derived from the first and second time derivatives of pressure or height at two or three points so that tilt values can be determined using an initial measurement and integrating appropriate derivatives of pressure or height. The measured substrate height and/or tilt values are supplied to the stage motion control system and used therein in the conventional manner.

In a variant of this embodiment, the seal member 12 is stationary relative to the substrate table rather than the projection lens, in which case the liquid height or pressure at two or three spaced apart locations gives a direct measurement of substrate table tilt, but no measurement of height.

Whilst specific embodiments of the invention have been described above, it will be appreciated that the invention may be practiced otherwise than as described. For example, whilst three sensors can be used to derive values for height and tilt about two horizontal axes, two or one sensor may be used if only one tilt value or only height is required. Often in a scanning apparatus, only a height and a tilt value about an axis parallel to the scanning direction is necessary. More sensors may be used for error averaging. Further, the measurement devices may be applied to the liquid supply system of Figures 2 and 3 to derive height and/or tilt values of the substrate in such an apparatus. The description is not intended to limit the invention.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a liquid supply system for at least partly filling a space between the final element of said projection system and an object positioned on the substrate table, with liquid;
**characterized by**:
a measurement device for obtaining the pressure and/or height of liquid in said space.

2. Apparatus according to claim 1, further comprising at least one further measurement device for obtaining the pressure and or height of said liquid at a point displaced in the plane of said substrate from said measurement device.

3. Apparatus according to claim 1 or 2, wherein the or each pressure sensor comprises a tube in liquid communication with liquid in the space, the tube having an open end and extending at least in part vertically; and a sensor for measuring the height of the liquid in said tube.

4. Apparatus according to any one of the preceding claims, wherein said liquid supply system comprises:
- a seal member extending along at least a part of the boundary of said space between the final element of said projection system and said substrate table; and
- a gas seal means for forming a gas seal between said seal member and the surface of said substrate.

5. Apparatus according to any one of the preceding claims further comprising positioning means for positioning said substrate table and control means for controlling said positioning means on the basis of height and/or tilt values derived from results from said measurement device.

6. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
- providing a liquid to at least partly fill a space between an object on the substrate table and a final element of a projection system used in said step of projecting;
**characterized by**
obtaining the pressure and/or height of liquid in said space.
